# EUROPÄISCHE PATENTSCHRIFT

(11) **EP 1 339 070 B1**
(45) Veröffentlichungstag und Bekanntmachung des Hinweises auf die Patenterteilung: **16.07.2008**
(21) Anmeldenummer: 02004145.5
(22) Anmeldetag: 25.02.2002
(51) Int. Cl.: G11C 16/26, G11C 7/06

(54) **Verfahren zum Auslesen des Inhalts einer Speicherzelle zum Speichern von Daten**
Readout method of a memory cell content for data storage
Procédé de lecture du contenu d'une cellule de mémoire pour le stockage de données

(43) Veröffentlichungstag der Anmeldung: 27.08.2003
(73) Patentinhaber: Infineon Technologies AG, 81669 München (DE)
(72) Erfinder: Baumgartner, Peter, Dr., 80331 München (DE)
(74) Vertreter: Repkow, Ines

(56) Entgegenhaltungen:
- EP-A- 0 982 779
- US-A- 5 748 530
- US-A- 6 015 738
- US-B1- 6 240 016
- PATENT ABSTRACTS OF JAPAN vol. 1998, no. 07, 31. März 1998 (1998-03-31) -& JP 06 275062 A (OLYMPUS OPTICAL CO LTD;SYMMETRICS CORP), 30. September 1994 (1994-09-30)

## Beschreibung

Die vorliegende Erfindung betrifft ein Verfahren gemäß dem Oberbegriff des Patentanspruchs 1.

Das Auslesen des Inhalts einer Speicherzelle kann sich insbesondere dann, wenn die Speicherzelle Bestandteil eines eine Vielzahl von Speicherzellen enthaltenden Speicherzellenfeldes ist, als problematisch erweisen.

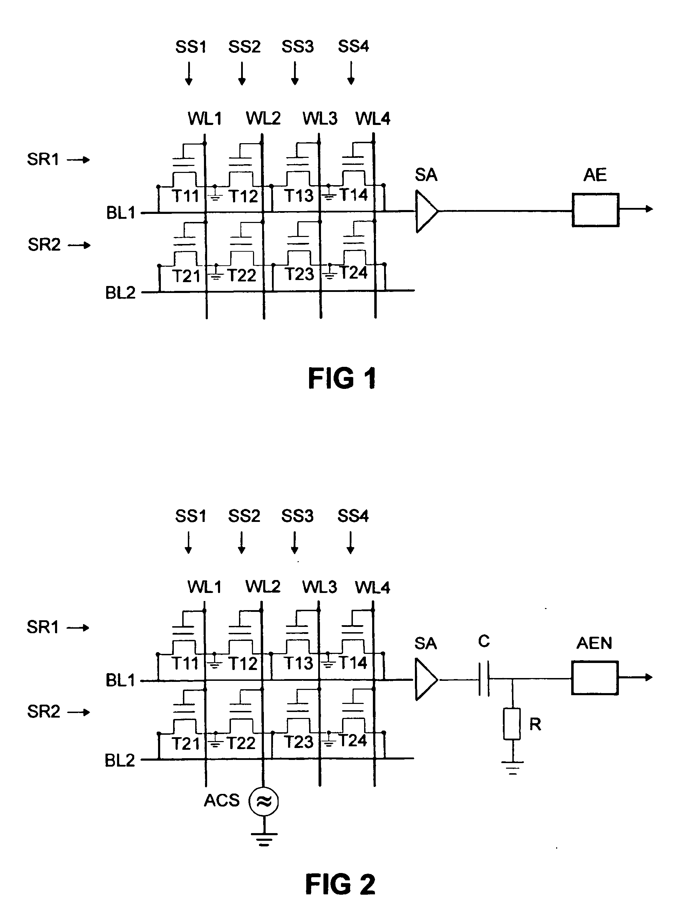

Ein eine Vielzahl von Speicherzellen enthaltendes Speicherzellenfeld ist in Figur 1 veranschaulicht.

Das in der Figur 1 gezeigte Speicherzellenfeld ist ein Flash-Speicher, und enthält eine Vielzahl von in einer Vielzahl von Reihen und in einer Vielzahl von Spalten angeordneten Speicherzellen, wobei die Speicherzellen jeweils durch einen Speichertransistor gebildet werden.

Im betrachteten Beispiel sind nur zwei Speicherzellen-Reihen SR1 und SR2, und vier Speicherzellen-Spalten SS1 bis SS4 dargestellt. In der Praxis sind üblicherweise jedoch sehr viel mehr Speicherzellen-Reihen und Speicherzellen-Spalten vorhanden.

Die Speichertransistoren sind mit den Bezugszeichen T11 bis T24 bezeichnet, und weisen jeweils einen als Steueranschluß dienenden Gate-Anschluß, einen Drain-Anschluß, einen Source-Anschluß, und ein Floating Gate auf. Der Aufbau und die Wirkungsweise solcher Speichertransistoren sind bekannt, so daß auf eine nähere Beschreibung derselben verzichtet werden kann.

Die Source-Anschlüsse aller Speichertransistoren sind über eine oder mehrere Source-Leitungen, welche in der Figur 1 nicht gezeigt sind, mit Masse verbunden. Die Drain-Anschlüsse der Speichertransistoren jeweils einer Speicherzellen-Reihe sind über Bit-Leitungen BL1 und BL2 miteinander verbunden. Die Gate-Anschlüsse der Speichertransistoren jeweils einer Speicherzellen-Spalte sind über Wortleitungen WL1 bis WL4 miteinander verbunden.

Darüber hinaus enthält die in der Figur 1 gezeigte Anordnung einen Leseverstärker SA, welcher eingangsseitig mit einer der Bitleitungen BL1 und BL2 verbunden ist, und abwechselnd mit diesen Bitleitungen verbunden werden kann. Der Vollständigkeit halber sei angemerkt, daß auch für jede Bitleitung ein eigener Leseverstärker vorgesehen sein kann.

Wenn der Inhalt eines Speichertransistors ausgelesen werden soll, wird dieser Speichertransistor über die Wortleitung und die Bitleitung, mit welcher er verbunden ist, mit bestimmten Spannungen beaufschlagt, und der über die betreffende Bitleitung fließende Strom ermittelt, wobei aus dem über die Bitleitung fließenden Strom ersichtlich ist, welchen Inhalt die durch den Speichertransistor gebildete Speicherzelle hat.

Die Spannung, mit welcher der Gate-Anschluß des auszulesenden Speichertransistors beaufschlagt wird, ist so bemessen, daß der auszulesende Speichertransistor dadurch in den leitenden Zustand versetzt wird, wenn er das Datum "1" speichert, und daß er gesperrt bleibt, wenn er das Datum "0" speichert (oder umgekehrt). Welches Datum die Speichertransistoren jeweils speichern, hängt vom Potential des Floating Gate ab, welches durch die Programmierung der Speichertransistoren auf gewünschte Werte bringbar ist. Die Größe der Spannung, mit welcher der Gate-Anschluß des auszulesenden Speichertransistors beaufschlagt wird, hängt ferner von der verwendeten Technologie ab. Ein gebräuchlicher Wert für die Spannung, mit welcher der Gate-Anschluß des auszulesenden Speichertransistors beaufschlagt wird, ist 3 V.

Die Spannung, mit welcher der Drain-Anschluß des auszulesenden Speichertransistors beaufschlagt wird, ist so bemessen, daß über die Bitleitung ein Strom fließt, der einerseits nicht zu groß ist, andererseits aber erkennen läßt, ob der auszulesende Speichertransistor leitet oder nicht. Ein gebräuchlicher Wert für die Spannung, mit welcher der Drain-Anschluß des auszulesenden Speichertransistors beaufschlagt wird, ist 1 V.

Wenn beispielsweise der Speichertransistor T12 ausgelesen werden soll, wird also während des Auslesens desselben an den Gate-Anschluß desselben über die Wortleitung WL2 eine Spannung von 3 V angelegt, und an den Drain-Anschluß über die Bitleitung BL1 eine Spannung von 1 V. Die anderen Wortleitungen, d.h. die Wortleitungen WL1, WL3, und WL4, sowie die anderen Bitleitungen, d.h. die Bitleitung BL2 sind mit Spannungen beaufschlagt, durch welche die mit ihnen verbundenen Speichertransistoren im sperrenden Zustand gehalten werden, also beispielsweise mit 0 V. Eine derartige Ansteuerung der Speichertransistoren bewirkt, daß über die Bitleitung BL1 ein Strom fließt, wobei dieser Strom klein ist, wenn der Speichertransistor T12 den Wert "0" speichert, also sperrt, und wobei dieser Strom groß ist, wenn der Speichertransistor T12 den Wert "1" speichert, also leitet.

Die Bitleitung BL1 ist mit dem Leseverstärker SA verbunden, welcher den über die Bitleitung BL1 fließenden Strom in eine Spannung umsetzt, in Abhängigkeit von deren Größe durch eine dem Leseverstärker SA nachgeschaltete Auswertungseinrichtung AE entschieden wird, welchen Inhalt der auszulesende Speichertransistor hat.

In der Praxis können bei der Ermittlung des Inhalts eines Speichertransistors Probleme auftreten. Genauer gesagt kann es vorkommen, daß der Inhalt eines Speichertransistors nicht richtig erkannt wird.

Dies kann unterschiedlichste Ursachen haben.

Eine der möglichen Ursachen besteht darin, daß ein Speichertransistor, in welchem eine "1" gespeichert ist, während des Auslesens von einem geringeren Strom durchflossen wird, als es üblicherweise der Fall ist. Dadurch fließt auch auf der Bitleitung ein geringerer Strom als es üblicherweise der Fall ist, und dies wiederum kann zur Folge haben, daß fälschlicherweise entschieden wird, daß im Speichertransistor eine "0" gespeichert ist.

Eine andere mögliche Ursache besteht darin, daß ein Speichertransistor, in welchem eine "0" gespeichert ist, während des Auslesens von einem größeren Strom durchflossen wird, als es üblicherweise der Fall ist. Dadurch fließt auch auf der Bitleitung ein größerer Strom als es üblicherweise der Fall ist, und dies wiederum kann zur Folge haben, daß fälschlicherweise entschieden wird, daß im Speichertransistor eine "1" gespeichert ist. Entsprechendes gilt für den Fall, daß die Ströme, die durch die nicht auszulesenden Speichertransistoren fließen, die an der selben Bitleitung angeschlossen sind wie der auszulesende Speichertransistor, bei einzelnen oder mehreren Transistoren größer sind als es üblicherweise der Fall ist.

Daß einzelne, mehrere, oder alle Speichertransistoren nicht von dem Strom durchflossen werden, von welchem sie üblicherweise durchflossen werden, liegt unter anderem daran, daß die Speichertransistoren nicht so hergestellt werden können, daß sämtliche Speichertransistoren stets genau die selben Eigenschaften aufweisen. Hinzu kommt, daß die Eigenschaften der Speichertransistoren auch von weiteren Parametern wie der Temperatur, Alter etc. abhängen.

Daß einzelne, mehrere, oder alle Speichertransistoren von anderen Strömen durchflossen werden als es üblicherweise der Fall ist, könnte dadurch verhindert werden, daß die einzelnen Speichertransistoren unabhängig voneinander individuell programmiert werden. Beispielsweise können die einzelnen Speichertransistoren unabhängig von den jeweils anderen Speichertransistoren so programmiert werden, daß sie die selbe Threshold-Spannung aufweisen. Die Threshold-Spannung ist die Spannungsdifferenz zwischen der Gatespannung und der Sourcespannung, ab welcher der jeweilige Speichertransistor vom nicht leitenden Zustand in den leitenden Zustand übergeht. Dabei kann so vorgegangen werden, daß nach erfolgter Programmierung eines Speichertransistors überprüft wird, ob dessen Threshold-Spannung einen bestimmten Wert aufweist oder innerhalb eines bestimmten Wertebereiches liegt, und daß dann, wenn dies nicht der Fall ist, eine Nach-Programmierung des betreffenden Speichertransistors durchgeführt wird. Eine derartige Vorgehensweise ist jedoch sehr aufwendig und erschwert auch das Testen des Speichers. Letzteres ist deshalb der Fall, weil dann - anders als bei Speichern ohne individuelle Programmierung - nicht mehr alle Speicherzellen gleichzeitig programmiert werden können.

Alternativ oder zusätzlich könnte vorgesehen werden, daß in jeder Speicherzelle ein zusätzlicher Auswahltransistor vorgesehen wird, welcher zu dem Speichertransistor in Reihe geschaltet ist und wie der Speichertransistor angesteuert wird. Dadurch könnte vermieden werden, daß durch die nicht auszulesenden Speichertransistoren Ströme fließen. Nachteilig an dieser Problemlösung ist jedoch, daß der Speicher dadurch sehr viel größer wird als ein keine Auswahltransistoren enthaltender Speicher.

Ein anderes Verfahren zum Auslesen des Inhalts einer Speicherzelle ist aus der EP-A-0982779 bekannt. Das in der EP-A-0982779 beschriebene Verfahren ist ein Verfahren gemäß dem Oberbegriff des Patentanspruchs 1. Allerdings weisen die Speicherzellen, deren Auslesen in der EP-A-0982779 beschrieben ist, einen völlig anderen Aufbau auf als die vorstehend beschriebenen Speicherzellen.

Der vorliegenden Erfindung liegt daher die Aufgabe zugrunde, eine Möglichkeit zu finden, durch welche der Inhalt von Speicherzellen, deren Inhalt durch ein Floating Gate eines in der Speicherzelle enthaltenen Transistors gespeichert wird, mit geringem Aufwand unter allen Umständen richtig ausgelesen werden kann.

Diese Aufgabe wird erfindungsgemäß durch das in Patentanspruch 1 beanspruchte Verfahren gelöst.

Das erfindungsgemäße Verfahren zeichnet sich dadurch aus, daß als Lesespannung, mit welcher der Gateanschluß eines die Speicherzelle bildenden und ein Floating Gate für die Informationsspeicherung aufweisenden Speichertransistors während des Auslesens der Speicherzelle beaufschlagt wird, eine Wechselspannung verwendet wird.

Dies hat den Effekt, daß der Strom, anhand dessen der Inhalt der Speicherzelle ermittelt wird, ebenfalls schwankt. Wählt man die Wechselspannung so, daß der Spannungsbereich, der von dieser Spannung während des Auslesens der auszulesenden Speicherzelle durchlaufen wird,
- Spannungen enthält, durch welche der dadurch angesteuerte Transistor wenigstens dann, wenn er eine "0" speichert, im nicht leitenden Zustand gehalten bzw. in den nicht leitenden zustand versetzt wird, und
- Spannungen enthält, durch welche der dadurch angesteuerte Transistor in den leitenden Zustand versetzt wird, wenn die auszulesende Speicherzelle eine "1" speichert, aber im nicht leitenden Zustand gehalten wird, wenn die auszulesende Speicherzelle eine "0" speichert, oder umgekehrt,

so hängt der Umfang der Stromschwankung im wesentlichen ausschließlich vom Inhalt der auszulesenden Speicherzelle ab. Folglich läßt sich aus dem Umfang der Stromschwankungen zweifelsfrei der Inhalt der Speicherzelle ermitteln.

Dies gilt auch dann, wenn die auszulesende Speicherzelle Bestandteil eines eine Vielzahl von Speicherzellen enthaltenden Speicherzellenfeldes ist. Steuert man nämlich die Transistoren der jeweils nicht auszulesenden Speicherzellenfeld-Spalten wie bisher mit einer Gleichspannung an, so sind die durch diese Transistoren fließenden Ströme während des Auslesens der auszulesenden Speicherzelle im wesentlichen konstant und beeinflussen den Umfang der Stromschwankung nicht oder allenfalls sehr geringfügig. Auch der Umstand, daß durch die Transistoren der nicht auszulesenden Speicherzellen während des Auslesens der auszulesenden Speicherzellen stark unterschiedliche Ströme fließen können, hat keinen Einfluß auf den Umfang der zur Bestimmung des Speicherzellen-Inhaltes herangezogenen Stromschwankung.

Es wurde mithin eine Möglichkeit gefunden, durch welche der_ Inhalt von Speicherzellen, deren Inhalt durch ein Floating Gate eines in der Speicherzelle enthaltenen Transistors (T11-T24) gespeichert wird, mit geringem Aufwand unter allen Umständen richtig ausgelesen werden kann.

Vorteilhafte Weiterbildungen der Erfindung sind den Unteransprüchen, der folgenden Beschreibung, und den Figuren entnehmbar.

Die Erfindung wird nachfolgend anhand eines Ausführungsbeispiels unter Bezugnahme auf die Figuren näher erläutert. Es zeigen
- Figur 1: den Aufbau einer herkömmlichen Anordnung zur Ermittlung des Inhaltes einer Speicherzelle eines eine Vielzahl von Speicherzellen enthaltenden Speicherzellenfeldes, und
- Figur 2: den Aufbau der im folgenden beschriebenen Anordnung zur Ermittlung des Inhaltes einer Speicherzelle eines eine Vielzahl von Speicherzellen enthaltenden Speicherzellenfeldes.

Das im folgenden beschriebene Verfahren wird anhand des Auslesens eines Flash-Speichers beschrieben.

Die besagten Transistoren der Speicherzellen sind im betrachteten Beispiel Speichertransistoren. Genauer gesagt wird jede Speicherzelle durch einen Speichertransistor gebildet. Die Speichertransistoren enthalten ein Floating Gate, welches durch das Löschen oder Programmieren geladen oder entladen wird, wobei es von der durch den jeweiligen Speichertransistor zu speichernden Information abhängt, in welchem Umfang das Floating Gate geladen oder entladen wird.

Ein Speicher, bei welchem das im folgenden beschriebene Verfahren zum Einsatz kommen kann, ist in Figur 2 gezeigt.

Die in der Figur 2 gezeigte Anordnung entspricht weitgehend der in der Figur 1 gezeigten und eingangs unter Bezugnahme darauf beschriebenen Anordnung. Mit den gleichen Bezugszeichen bezeichnete Komponenten sind identische oder einander entsprechende Komponenten.

Im Gegensatz zu der in der Figur 1 gezeigten Anordnung wird bei der in der Figur 2 gezeigten Anordnung dem Gate-Anschluß des jeweils auszulesenden Speichertransistors während des Auslesens eine Wechselspannung zugeführt. Diese Wechselspannung wird im betrachteten Beispiel durch eine Wechselspannungsquelle ACS erzeugt, und dem Gate-Anschluß des auszulesenden Speichertransistors über die Wortleitung, mit welcher dieser verbunden ist, zugeführt. Die anderen Wortleitungen und die Bitleitungen werden wie bisher mit Gleichspannungen beaufschlagt.

Wenn beispielsweise der Speichertransistor T12 ausgelesen werden soll, wird also während des Auslesens desselben an den Gate-Anschluß desselben über die Wortleitung WL2 die von der Wechselspannungsquelle ACS erzeugte Wechselspannung angelegt, und an den Drain-Anschluß desselben über die Bitleitung BL1 eine Gleichspannung, beispielsweise 1 V. Die anderen Wortleitungen, d.h. die Wortleitungen WL1, WL3, und WL4, sowie die anderen Bitleitungen, d.h. die Bitleitung BL2 sind mit Spannungen beaufschlagt, durch welche die mit ihnen verbundenen Speichertransistoren im nicht leitenden Zustand gehalten werden bzw. in den nicht leitenden Zustand versetzt werden, also beispielsweise mit 0 V.

Der Spannungsbereich, der während des Auslesens der auszulesenden Speicherzelle von der von der Wechselspannungsquelle ACS erzeugten Wechselspannung durchlaufen wird,
- enthält Spannungen, durch welche der dadurch angesteuerte Speichertransistor unabhängig davon, ob er eine "0" oder eine "1" speichert, im nicht leitenden Zustand gehalten bzw. in den nicht leitenden Zustand versetzt wird, und
- enthält Spannungen, durch welche der dadurch angesteuerte Speichertransistor in den leitenden Zustand versetzt wird, wenn der Speichertransistor eine "1" speichert, aber im nicht leitenden Zustand gehalten wird, wenn der Speichertransistor eine "0" speichert.

Wie später noch besser verstanden werden wird, können die erstgenannten Spannungen auch solche Spannungen sein, durch welche der dadurch angesteuerte Speichertransistor dann, wenn er eine "0" speichert, im nicht leitenden Zustand gehalten bzw. in den nicht leitenden zustand versetzt wird, und dann, wenn er eine "1" speichert, in einen schwach leitenden versetzt wird, wobei der schwach leitende Zustand, ein Zustand ist, in welchem der Transistor von einem erheblich kleineren Strom durchflossen wird als in dem stärker leitenden Zustand, den der Transistor einnimmt, wenn dieser durch die vorstehend an zweiter Stelle genannten Spannungen angesteuert wird.

Wie bei der herkömmlichen Anordnung gemäß Figur 1 fließt auch bei der in der Figur 2 gezeigten Anordnung über die Bitleitung, die mit dem auszulesenden Speichertransistor, genauer gesagt mit dem Drain-Anschluß desselben verbunden ist, ein Strom. Dieser Strom setzt sich aus zwei Komponenten zusammen, nämlich
- einer ersten Komponente, welche durch den Strom gebildet wird, welcher durch den auszulesenden Speichertransistor fließt, und
- einer zweiten Komponente, welche durch die Summe der Ströme gebildet wird, die durch die nicht auszulesenden Speichertransistoren fließen, deren Drain-Anschlüsse mit der selben Bitleitung wie der auszulesende Speichertransistor verbunden sind.

Die Größe der zweiten Strom-Komponente ist während der Dauer des Auslesens des auszulesenden Speichertransistors zeitlich konstant, weil sich die an die nicht auszulesenden Speichertransistoren angelegten Spannungen während des Auslesens des auszulesenden Speichertransistors nicht verändern und sich folglich auch die durch diese Speichertransistoren fließenden Leckströme nicht verändern. Dabei spielt es keine Rolle, ob die Leckströme durch die nicht auszulesenden Speichertransistoren bestimmte Werte aufweisen; diese können unabhängig voneinander beliebig groß sein.

Die Größe der ersten Strom-Komponente variiert während der Dauer des Auslesens des auszulesenden Speichertransistors, weil sich die an den Gate-Anschluß des auszulesenden Speichertransistors angelegte Spannung während des Auslesens des auszulesenden Speichertransistors ändert.

Der Umfang, in welchem die Größe der ersten Strom-Komponente während der Dauer des Auslesens des auszulesenden Speichertransistors schwankt, ist gering, wenn der Speichertransistor eine "0" speichert, weil sich dann nur der Leckstrom verändert.

Der Umfang, in welchem die Größe der ersten Strom-Komponente während der Dauer des Auslesens des auszulesenden Speichertransistors schwankt, ist groß, wenn der Speichertransistor eine "1" speichert, weil der auszulesende Speichertransistor dann während der Dauer des Auslesens des auszulesenden Speichertransistors vom nicht leitenden Zustand oder vom schwach leitenden Zustand in den leitenden Zustand und/oder umgekehrt gelangt.

Nach alledem schwankt der während der Dauer des Auslesens des auszulesenden Speichertransistors über die Bitleitung fließende Strom, wobei die Größe der Schwankung anzeigt, ob im auszulesenden Speichertransistor eine "0" oder eine "1" gespeichert ist.

Der Inhalt des auszulesenden Speichertransistors läßt sich folglich ermitteln, indem überprüft wird, ob die Größe der Schwankungen des über die Bitleitung fließenden Stromes einen bestimmten Wert übersteigt oder nicht. Übersteigt die Größe der Schwankungen den bestimmten Wert, so ist im Speichertransistor eine "1" gespeichert; übersteigt die Größe der Schwankungen den bestimmten Wert nicht, so ist im Speichertransistor eine "0" gespeichert.

Eine solche Ermittlung läßt sich mit sehr geringem Aufwand durchführen. Eine Möglichkeit hierzu ist in der Figur 2 dargestellt.

Demnach wird der über die Bitleitung fließende Strom zunächst wie bei der in der Figur 1 gezeigten herkömmlichen Anordnung durch einen Leseverstärker SA verstärkt und in eine Spannung umgewandelt. Dabei kann der selbe Leseverstärker verwendet werden wie bei herkömmlichen Verfahren zum Auslesen des Inhalts einer Speicherzelle.

Die vom Leseverstärker SA ausgegebene Spannung wird durch einen im betrachteten Beispiel durch einen Kondensator C und einen Widerstand R gebildeten Hochpaß einer Hochpaß-Filterung unterzogen. Hierbei werden aus der vom Leseverstärker SA ausgegebenen Spannung die Gleichspannungsanteile herausgefiltert und nur die Wechselspannungsanteile durchgelassen.

Das gefilterte Signal wird einer Auswertungseinrichtung AEN zugeführt. Diese Auswertungseinrichtung AEN ermittelt die Differenz zwischen der maximalen Spannung und der minimalen Spannung, die während der Dauer des Auslesens der auszulesenden Speicherzelle auftreten, und legt abhängig hiervon fest, ob der Inhalt des auszulesenden Speichertransistors den Wert "0" oder den Wert "1" aufweist. Es wird entschieden, daß der Inhalt des auszulesenden Speichertransistors "0" ist, wenn Differenz einen bestimmten Wert unterschreitet, und daß der Inhalt des auszulesenden Speichertransistors "1" ist, wenn Differenz den bestimmten Wert überschreitet (oder umgekehrt).

Der bestimmte Wert ist so gewählt, daß er größer ist als die maximale Schwankung des Leckstromes, der durch den auszulesenden Speichertransistor fließen kann, und kleiner ist als die minimale Differenz zwischen den Strömen, die den auszulesenden Speichertransistor im leitenden Zustand desselben und im nicht oder schwach leitenden Zustand desselben durchfließen. Genau genommen sind bei der Festlegung des bestimmten Wertes natürlich nicht die Ströme und Stromschwankungen, sondern die Spannungen und Spannungsschwankungen des Leseverstärker-Ausgangssignals relevant.

Der zeitliche Verlauf der Wechselspannung, die während des Auslesens der jeweils auszulesenden Speicherzelle an den Gateanschluß des Speichertransistors derselben angelegt wird, kann prinzipiell beliebig sein, beispielsweise sinusförmig, rechteckförmig, sägezahnförmig, etc. Die Wechselspannung kann auch durch eine Impulsfolge gebildet werden, wobei es ausreicht, wenn die Wechselspannungsquelle ACS während des Auslesens einer Speicherzelle nur einen einzigen kurzen Spannungsimpuls erzeugt. Wichtig ist aber, daß die Wechselspannung während der Dauer des Auslesens der auszulesenden Speicherzelle mindestens einmal den vorstehend definierten Spannungsbereich durchläuft.

Durch das beschriebene Verfahren ist es unabhängig von den Einzelheiten der praktischen Realisierung möglich, den Inhalt einer Speicherzelle mit geringem Aufwand unter allen Umständen richtig auszulesen.

### Bezugszeichenliste

- ACS: Wechselspannungsquelle
- AE: Auswertungseinrichtung
- AEN: Auswertungseinrichtung
- BLx: Bitleitung
- C: Kondensator
- R: Widerstand
- SA: Leseverstärker
- SRx: Speicherzellen-Reihe
- SSx: Speicherzellen-Spalte
- Tx: Transistor
- WLx: Wortleitung

## Patentansprüche

1. Verfahren zum Auslesen des Inhalts einer Speicherzelle zum Speichern von Daten,
- wobei der Inhalt der Speicherzelle abhängig von dem Strom ermittelt wird, der während des Auslesens der Speicherzelle durch einen in dieser Speicherzelle enthaltenen Transistor (T11-T24) fließt, und
- wobei als Lesespannung, mit welcher der Gateanschluß des Transistors (T11-T24) während des Auslesens der Speicherzelle beaufschlagt wird, eine Wechselspannung verwendet wird, durch welche der Transistor (T11-T24) der auszulesenden Speicherzelle während des Auslesens derselben mindestens einmal vom leitenden in den nicht oder schwachleitenden Zustand und/oder umgekehrt versetzt wird,
**dadurch gekennzeichnet,**
- **daß** der Transistor (T11-T24) der auszulesenden Speicherzelle ein Speichertransistor ist, und
- **daß** die in der auszulesenden Speicherzelle gespeicherte Information durch ein Floating Gate des in der Speicherzelle enthaltenen Speichertransistors (T11-T24) gespeichert wird.

2. Verfahren nach Anspruch 1,
**dadurch gekennzeichnet,**
**daß** der Spannungsbereich, der von der Lesespannung während des Auslesens der auszulesenden Speicherzelle durchlaufen wird,
- Spannungen enthält, durch welche der dadurch angesteuerte Transistor (T11-T24) unabhängig davon, ob er eine "0" oder eine "1" speichert, im nicht leitenden Zustand gehalten bzw. in den nicht leitenden Zustand versetzt wird, und
- Spannungen enthält, durch welche der dadurch angesteuerte Transistor (T11-T24) in den leitenden Zustand versetzt wird, wenn die auszulesende Speicherzelle eine "1" speichert, aber im nicht leitenden Zustand gehalten wird, wenn die auszulesende Speicherzelle eine "0" speichert, oder umgekehrt.

3. Verfahren nach Anspruch 1,
**dadurch gekennzeichnet,**
**daß** der Spannungsbereich, der von der Lesespannung während des Auslesens der auszulesenden Speicherzelle durchlaufen wird,
- Spannungen enthält, durch welche der dadurch angesteuerte Transistor (T11-T24) dann, wenn er eine "0" speichert, im nicht leitenden Zustand gehalten bzw. in den nicht leitenden Zustand versetzt wird, und dann, wenn er eine "1" speichert, in einen schwach leitenden Zustand versetzt wird, und
- Spannungen enthält, durch welche der dadurch angesteuerte Transistor (T11-T24) in den leitenden Zustand versetzt wird, wenn die auszulesende Speicherzelle eine "1" speichert, aber im nicht leitenden Zustand gehalten wird, wenn die auszulesende Speicherzelle eine "0" speichert, oder umgekehrt.

4. Verfahren nach einem der vorhergehenden Ansprüche,
**dadurch gekennzeichnet,**
**daß** als Lesespannung ein Spannungsimpuls oder eine Folge von Spannungsimpulsen verwendet wird, durch welche der Transistor (T11-T24) der auszulesenden Speicherzelle während des Auslesens derselben mindestens einmal vom leitenden in den nicht oder schwach leitenden Zustand und/oder umgekehrt versetzbar ist.

5. Verfahren nach einem der vorhergehenden Ansprüche,
**dadurch gekennzeichnet,**
**daß** dem Drain-Anschluß des Transistors (T11-T24) der auszulesenden Speicherzelle eine Spannung zugeführt wird, die ungleich 0 V ist.

6. Verfahren nach einem der vorhergehenden Ansprüche,
**dadurch gekennzeichnet,**
**daß** die dem Drain-Anschluß des Transistors (T11-T24) der auszulesenden Speicherzelle zugeführte Spannung dem Drain-Anschluß über eine Bitleitung (BL1, BL2) zugeführt wird.

7. Verfahren nach einem der vorhergehenden Ansprüche,
**dadurch gekennzeichnet,**
**daß** die auszulesende Speicherzelle eine Speicherzelle eines eine Vielzahl von Speicherzellen umfassenden Speicherzellenfeldes ist.

8. Verfahren nach Anspruch 5 und 6,
**dadurch gekennzeichnet,**
**daß** die Bitleitung (BL1, BL2) auch mit den Drain-Anschlüssen von Transistoren (T11-T24) von gerade nicht auszulesenden Speicherzellen verbunden ist.

9. Verfahren nach Anspruch 8,
**dadurch gekennzeichnet,**
**daß** von den Transistoren (T11-T24), deren Drain-Anschlüsse mit der Bitleitung (BL1, BL2) verbunden sind, mit welcher auch der Transistor (T11-T24) der gerade auszulesenden Speicherzelle verbunden ist, die Gateanschlüsse mit einer Spannung beaufschlagt werden, durch welche diese Transistoren (T11-T24) im nicht leitenden Zustand gehalten werden.

10. Verfahren nach Anspruch 8 oder 9,
**dadurch gekennzeichnet,**
**daß** von den Transistoren (T11-T24), deren Drain-Anschlüsse mit der Bitleitung (BL1, BL2) verbunden sind, mit welcher auch der Transistor (T11-T24) der gerade auszulesenden Speicherzelle verbunden ist, die Gateanschlüsse mit einer Gleichspannung beaufschlagt werden.

11. Verfahren nach Anspruch 6,
**dadurch gekennzeichnet,**
**daß** der Inhalt der auszulesenden Speicherzelle abhängig vom zeitlichen Verlauf des über die Bitleitung (BL1, BL2) fließenden Stromes festgelegt wird.

12. Verfahren nach Anspruch 6,
**dadurch gekennzeichnet,**
**daß** der Inhalt der auszulesenden Speicherzelle abhängig vom Umfang festgelegt wird, in welchem der über die Bitleitung (BL1, BL2) fließende Strom während des Auslesens der auszulesenden Speicherzelle schwankt.

13. Verfahren nach Anspruch 12,
**dadurch gekennzeichnet,**
**daß** festgelegt wird, daß der Inhalt der auszulesenden Speicherzelle "0" ist, wenn der Umfang der Schwankung des über die Bitleitung (BL1, BL2) fließenden Stromes unter einem bestimmten Wert liegt, und daß der Inhalt der auszulesenden Speicherzelle "1" ist, wenn der Umfang der Schwankung des über die Bitleitung (BL1, BL2) fließenden Stromes über dem bestimmten Wert liegt, oder umgekehrt.

14. Verfahren nach Anspruch 13,
**dadurch gekennzeichnet,**
**daß** der bestimmte Wert so gewählt wird, daß er größer ist als die maximale Schwankung des Leckstromes, der durch den Transistor (T11-T24) der auszulesenden Speicherzelle fließen kann, und kleiner ist als die minimale Differenz zwischen den Strömen, die den Transistor (T11-T24) der auszulesenden Speicherzelle im leitenden Zustand desselben und im nicht oder schwach leitenden Zustand desselben durchfließen.

## Claims

1. Method for reading out the content of a memory cell for storing data,
- wherein the content of the memory cell is determined depending on the current which flows, during the read-out of the memory cell, through a transistor (T11-T24) contained in said memory cell, and
- wherein an AC voltage is used as read voltage applied to the gate terminal of the transistor (T11-T24) during the read-out of the memory cell, by means of which AC voltage the transistor (T11-T24) of the memory cell to be read, during the read-out of the latter, is put at least once from the conducting state into the non-conducting or weakly conducting state, and/or vice versa,
**characterized**
- **in that** the transistor (T11-T24) of the memory cell to be read is a memory transistor, and
- **in that** the information stored in the memory cell to be read is stored by a floating gate of the memory transistor (T11-T24) contained in the memory cell.

2. Method according to Claim 1,
**characterized**
**in that** the voltage range traversed by the read voltage during the read-out of the memory cell to be read
- contains voltages by means of which the transistor (T11-T24) driven thereby, independently of whether it stores a "0" or a "1", is held in the non-conducting state or is put into the non-conducting state, and
- contains voltages by means of which the transistor (T11-T24) driven thereby is put into the conducting state if the memory cell to be read stores a "1", but is held in the non-conducting state if the memory cell to be read stores a "0" or vice versa.

3. Method according to Claim 1,
**characterized**
**in that** the voltage range traversed by the read voltage during the read-out of the memory cell to be read
- contains voltages by means of which the transistor (T11-T24) driven thereby is held in the non-conducting state or is put into the non-conducting state when it stores a "0" and is put into a weakly conducting state when it stores a "1", and
- contains voltages by means of which the transistor (T11-T24) driven thereby is put into the conducting state if the memory cell to be read stores a "1", but is held in the non-conducting state if the memory cell to be read stores a "0" or vice versa.

4. Method according to any of the preceding claims,
**characterized**
**in that** the read voltage used is a voltage pulse or a sequence of voltage pulses by means of which the transistor (T11-T24) of the memory cell to be read, during the read-out of the latter, can be put at least once from the conducting state into the non-conducting or weakly conducting state, and/or vice versa.

5. Method according to any of the preceding claims,
**characterized**
**in that** a voltage that is not equal to 0 V is fed to the drain terminal of the transistor (T11-T24) of the memory cell to be read.

6. Method according to any of the preceding claims,
**characterized**
**in that** the voltage fed to the drain terminal of the transistor (T11-T24) of the memory cell to be read is fed to the drain terminal via a bit line (BL1, BL2).

7. Method according to any of the preceding claims,
**characterized**
**in that** the memory cell to be read is a memory cell of a memory cell array comprising a multiplicity of memory cells.

8. Method according to Claims 5 and 6,
**characterized**
**in that** the bit line (BL1, BL2) is also connected to the drain terminals of transistors (T11-T24) of memory cells that are not currently to be read.

9. Method according to Claim 8,
**characterized**
**in that** of the transistors (T11-T24) whose drain terminals are connected to the bit line (BL1, BL2) to which the transistor (T11-T24) of the memory cell that is currently to be read is also connected, the gate terminals have applied to them a voltage by means of which said transistors (T11-T24) are held in the non-conducting state.

10. Method according to Claim 8 or 9,
**characterized**
**in that** of the transistors (T11-T24) whose drain terminals are connected to the bit line (BL1, BL2) to which the transistor (T11-T24) of the memory cell that is currently to be read is also connected, the gate terminals have a DC voltage applied to them.

11. Method according to Claim 6,
**characterized**
**in that** the content of the memory cell to be read is defined depending on the temporary profile of the current flowing via the bit line (BL1, BL2).

12. Method according to Claim 6,
**characterized**
**in that** the content of the memory cell to be read is defined depending on the extent to which the current flowing via the bit line (BL1, BL2) fluctuates during the read-out of the memory cell to be read.

13. Method according to Claim 12,
**characterized**
**in that** it is defined that the content of the memory cell to be read is "0" if the extent of the fluctuation of the current flowing via the bit line (BL1, BL2) lies below a specific value, and that the content of the memory cell to be read is "1" if the extent of the fluctuation of the current flowing via the bit line (BL1, BL2) lies above the specific value, or vice versa.

14. Method according to Claim 13,
**characterized**
**in that** the specific value is chosen such that it is greater than the maximum fluctuation of the leakage current which can flow through the transistor (T11-T24) of the memory cell to be read, and is less than the minimum difference between the currents which flow through the transistor (T11-T24) of the memory cell to be read in the conducting state of said transistor and in the non-conducting or weakly conducting state of said transistor.

## Revendications

1. Procédé pour lire le contenu d'une cellule de mémoire destinée à mémoriser des données,
- le contenu de la cellule de mémoire étant déterminé en fonction du courant qui circule pendant la lecture de la cellule de mémoire à travers un transistor (T11 - T24) qui se trouve dans cette cellule de mémoire et
- la tension de lecture à laquelle est soumise la borne de gâchette du transistor (T11 - T24) pendant la lecture de la cellule de mémoire étant une tension alternative par le biais de laquelle le transistor (T11 - T24) de la cellule de mémoire à lire est amené, pendant la lecture de celle-ci, au moins une fois de l'état passant à l'état non ou faiblement passant et/ou inversement,
**caractérisé en ce**
- **que** le transistor (T11 - T24) de la cellule de mémoire à lire est un transistor mémoire et
- **que** les informations mémorisées dans la cellule de mémoire à lire sont mémorisées par le biais d'une gâchette flottante du transistor mémoire (T11 - T24) qui se trouve dans la cellule de mémoire.

2. Procédé selon la revendication 1, **caractérisé en ce que** la plage de tension que parcourt la tension de lecture pendant la lecture de la cellule de mémoire à lire
- contient des tensions par lesquelles le transistor (T11 - T24) commandé par celles-ci est maintenu dans l'état non passant ou amené dans l'état non passant, et ce indépendamment du fait qu'il mémorise un « 0 » ou un « 1 » et
- contient des tensions par lesquelles le transistor (T11 - T24) commandé par celles-ci est amené dans l'état passant lorsque la cellule de mémoire à lire mémorise un « 1 », mais est maintenu dans l'état non passant lorsque la cellule de mémoire à lire mémorise un « 0 », ou inversement.

3. Procédé selon la revendication 1, **caractérisé en ce que** la plage de tension que parcourt la tension de lecture pendant la lecture de la cellule de mémoire à lire
- contient des tensions par lesquelles le transistor (T11 - T24) commandé par celles-ci, lorsqu'il mémorise un « 0 », est maintenu dans l'état non passant ou amené dans l'état non passant et, lorsqu'il mémorise un « 1 », est amené dans un état faiblement passant et
- contient des tensions par lesquelles le transistor (T11 - T24) commandé par celles-ci est amené dans l'état passant lorsque la cellule de mémoire à lire mémorise un « 1 », mais est maintenu dans l'état non passant lorsque la cellule de mémoire à lire mémorise un « 0 », ou inversement.

4. Procédé selon l'une des revendications précédentes, **caractérisé en ce que** la tension de lecture utilisée est une impulsion de tension ou une séquence d'impulsions de tension par le biais de laquelle le transistor (T11 - T24) de la cellule de mémoire à lire, pendant la lecture de celle-ci, peut être amené au moins une fois de l'état passant dans l'état non ou faiblement passant et/ou inversement.

5. Procédé selon l'une des revendications précédentes, **caractérisé en ce qu'**une tension différente de 0 V est acheminée à la borne de drain du transistor (T11 -T24) de la cellule de mémoire à lire.

6. Procédé selon l'une des revendications précédentes, **caractérisé en ce que** la tension acheminée à la borne de drain du transistor (T11 -T24) de la cellule de mémoire à lire est acheminée à la borne de drain par le biais d'une ligne binaire (BL1, BL2).

7. Procédé selon l'une des revendications précédentes, **caractérisé en ce que** la cellule de mémoire à lire est une cellule de mémoire d'une matrice de cellules de mémoire comprenant un grand nombre de cellules de mémoire.

8. Procédé selon les revendications 5 et 6, **caractérisé en ce que** la ligne binaire (BL1, BL2) est également reliée avec les bornes de drain des transistors (T11 - T24) des cellules de mémoire qui ne sont pas en cours de lecture.

9. Procédé selon la revendication 8, **caractérisé en ce que** les bornes de gâchette des transistors (T11 - T24) dont les bornes de drain sont reliées avec la ligne binaire (BL1, BL2), avec laquelle est également relié le transistor (T11 - T24) de la cellule de mémoire qui est en cours de lecture, sont soumises à une tension par laquelle ces transistors (T11 - T24) sont maintenus dans un état non passant.

10. Procédé selon la revendication 8 ou 9, **caractérisé en ce que** les bornes de gâchette des transistors (T11 - T24) dont les bornes de drain sont reliées avec la ligne binaire (BL1, BL2), avec laquelle est également relié le transistor (T11 - T24) de la cellule de mémoire qui est en cours de lecture, sont soumises à une tension continue.

11. Procédé selon la revendication 6, **caractérisé en ce que** le contenu de la cellule de mémoire à lire est déterminé en fonction du tracé dans le temps du courant qui circule à travers la ligne binaire (BL1, BL2).

12. Procédé selon la revendication 6, **caractérisé en ce que** le contenu de la cellule de mémoire à lire est déterminé en fonction de l'ampleur de la fluctuation du courant qui circule à travers la ligne binaire (BL1, BL2) pendant la lecture de la cellule de mémoire à lire.

13. Procédé selon la revendication 12, **caractérisé en ce qu'**il est défini que le contenu de la cellule de mémoire à lire est « 0 » lorsque l'ampleur de la fluctuation du courant qui circule à travers la ligne binaire (BL1, BL2) est inférieure à une valeur donnée et que le contenu de la cellule de mémoire à lire est « 1 » lorsque l'ampleur de la fluctuation du courant qui circule à travers la ligne binaire (BL1, BL2) est supérieure à la valeur donnée.

14. Procédé selon la revendication 13, **caractérisé en ce que** la valeur donnée est choisie de telle sorte qu'elle est supérieure à la fluctuation maximale du courant de fuite qui peut circuler à travers le transistor (T11 - T24) de la cellule de mémoire à lire et inférieure à la différence minimale entre les courants qui circulent à travers le transistor (T11 - T24) de la cellule de mémoire à lire à l'état passant de celui-ci et à l'état non ou faiblement passant de celui-ci.
